# EUROPEAN PATENT SPECIFICATION

(11) **EP 3 876 690 B1**
(45) Date of publication and mention of the grant of the patent: **12.06.2024**
(21) Application number: 18938294.8
(22) Date of filing: 31.10.2018
(51) Int. Cl.: H05K 13/08

(54) **SUBSTRATE WORK MACHINE AND MOVABLE HEAD**
SUBSTRATBEARBEITUNGSMASCHINE UND BEWEGLICHER KOPF
MACHINE DE TRAVAIL SUR SUBSTRAT ET TÊTE MOBILE

(43) Date of publication of application: 08.09.2021
(73) Proprietor: Fuji Corporation, Chiryu-shi, Aichi 472-8686 (JP)
(72) Inventor: HASHIMOTO Mitsuhiro, Chiryu-shi, Aichi 472-8686 (JP)
(74) Representative: Grünecker Patent- und Rechtsanwälte PartG mbB
(86) International application number: PCT/JP2018/040569
(87) International publication number: WO 2020/090048

(56) References cited:
- WO-A1-2014/091577
- JP-A- H11 187 693
- JP-A- 2002 137 185
- JP-A- 2003 258 496
- JP-A- 2009 261 245
- JP-A- 2014 180 863
- JP-A- 2018 157 003

## Description

### Technical Field

The present invention relates to a board work machine and a moving head.

### Background Art

Board work machines produce board products by performing board work using a moving head. Patent Literature 1 discloses a component mounting machine as a board work machine. The component mounting machine picks up components with a mounting head as a moving head and mounts picked up components to a predetermined position on a board. Productivity of the board work is improved by reducing the size and weight of the moving head.

WO 2014/091577 A1 relates to correction of a drift in an optical communication sensor in a component mounting apparatus. The optical communication sensor comprises an inclination sensor which may be prone to a temperature drift.

JP 2018157003 A relates to substrate processing using a head that is driven by motors. The motors are cooled using fans. An abnormality detection device determines when a fan experiences an abnormality and a notification of the abnormality is sent to an operator.

### Patent Literature

Patent Literature 1: Japanese Patent Laid-Open No. 2017-183586

### Summary of the Invention

### Technical Problem

The moving head has various additional functions required for handling the production of various board products. In this situation, the moving head may, for example, mount components that generate heat during the operation. In such cases, it is desirable to protect components having a relatively low heat resistance disposed inside the moving head from heat and maintain normal operation of the moving head.

It is an object of the present invention to provide a board work machine and a moving head that maintain normal operation of the moving head while managing temperature inside the moving head.

### Solution to Problem

The invention is defined by the features of the independent claims. Any reference to inventions or embodiments not falling within the scope of the independent claims are to be interpreted as examples useful for understanding the invention.

The present specification discloses a board work machine comprising: a moving head, used for board work, provided inside the board work machine in a manner allowing movement in the horizontal direction; a temperature acquisition section configured to acquire the temperature inside the moving head; and a head control section configured to control the operation of the moving head during board work based on the temperature acquired by the temperature acquisition section.

The present specification discloses a moving head, used for board work, provided inside the board work machine in a manner allowing movement in the horizontal direction, wherein the moving head comprises: a housing; a temperature acquisition section configured to acquire the temperature inside the housing; and a head control section configured to control the operation of the moving head, during board work, based on the temperature acquired by the temperature acquisition section.

### Advantageous Effect of the Invention

With such a configuration, the operation of the moving head is controlled in accordance with the internal temperature. With this configuration, temperature management becomes possible inside the moving head, enabling normal operation of the moving head to be maintained.

### Brief Description of Drawings

[Fig. 1] A schematic diagram showing a configuration of a component mounting machine of the embodiment.
[Fig. 2] A side view schematically showing a mounting head.
[Fig. 3] A front view schematically showing a portion of a control board in Fig. 2.
[Fig. 4] A flowchart showing a temperature management process by the component mounting machine.
[Fig. 5] A front view schematically showing a portion of the control board in a modified embodiment.

### Description of Embodiments

### 1. Overview of the board work and the moving head

Hereinafter, an embodiment of a board work machine and a moving head will be described with reference to the drawings. The moving head is provided so as to be movable in the horizontal direction inside the board work machine and is to be used for board work (i.e., a predetermined operation on a board). The present embodiment shows a situation in which the board work machine is component mounting machine 1 and the moving head is mounting head 40 of component mounting machine 1.

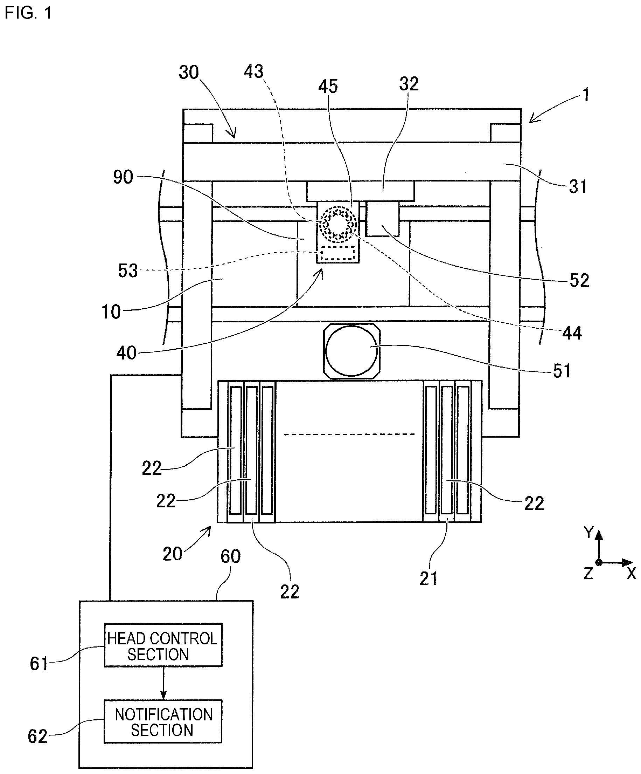

Component mounting machine 1 constitutes a production line for producing a board product. The production line is configured by, for example, multiple board work machines, including component mounting machine 1, installed along the conveyance direction of board 90 (see Fig.1). Aside from component mounting machine 1, board work machines constituting the production line include, for example, a printing machine for printing solder on board 90, a reflow furnace for performing soldering by melting solder on board 90 by heating, an inspecting machine for testing whether the appearance or function of a produced board product is normal.

The configuration of the production line can be appropriately subjected to additions or changes in accordance with, for example, the type of board product to be produced. Specifically, in the production line, a buffer device for temporarily holding board 90 to be conveyed, a board supply device, a board reversing device, various inspection devices, a shield mounting device, an adhesive coating device, a chip transfer device, an ultraviolet irradiation device, and the like can be installed as appropriate.

### 2. Configuration of Component Mounting Machine 1

Component mounting machine 1 executes a mounting process of mounting components on board 90. Component mounting machine 1 includes, as shown in Fig. 1, board conveyance device 10, component supply device 20, component conveyance device 30, component camera 51, board camera 52, head camera unit 53, and control device 60. In the following description, the horizontal direction of component mounting machine 1 is the X-direction; the front-rear direction of component mounting machine 1, which is a horizontal direction orthogonal to the X-direction, is the Y-direction; and the vertical direction orthogonal to the X-direction and Y-direction (the front-rear direction in Fig. 1) is the Z-direction.

Board conveyance device 10 is constituted by a belt conveyor and a positioning device or the like. Board conveyance device 10, together with sequentially conveying boards 90 in the conveyance direction, positions board 90 at a predetermined position inside the board work machine. After the mounting process is completed, board conveyance device 10 conveys out board 90 outside of component mounting machine 1. Component supply device 20 supplies components to be mounted on board 90. Component supply device 20 has feeders 22 set in multiple slots 21. Feeder 22 feeds and moves a carrier tape containing a large number of components and supplies the components so that the components can be picked up.

Component conveyance device 30 transfers components supplied by component supply device 20 to a predetermined mounting position on board 90 conveyed into component mounting machine 1 by board conveyance device 10. Head driving device 31 of component conveyance device 30 moves moving table 32 in the horizontal direction (i.e., the X-direction and Y-direction) by a linear motion mechanism. Mounting head 40 is fixed to moving table 32 by a clamp member (not shown).

Mounting head 40 picks up components supplied by component supply device 20 with a holding member and mounts the components to a predetermined mounting position of board 90. Suction nozzle 44 for picking up components by negative pressure air, a chuck for clamping components, or the like can be used as a holding member. A detailed configuration of mounting head 40 will be described later.

Part camera 51, board camera 52, and head camera unit 53 are digital imaging devices having an imaging device such as a CMOS. Part camera 51, board camera 52 and head camera unit 53 perform imaging based on control signals and transmit image data acquired by imaging. Component camera 51 is configured to image components held by suction nozzle 44 of mounting head 40 from below. Board camera 52 is configured to image board 90 from above.

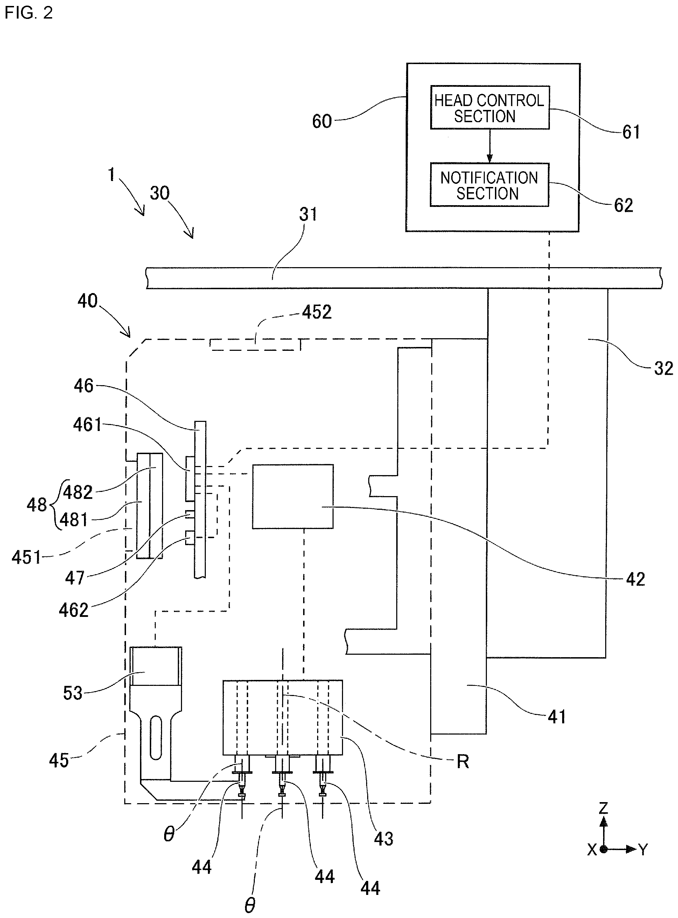

Head camera unit 53 is provided inside mounting head 40, as shown in Fig. 2, and moves integrally with mounting head 40 along with the movement of moving table 32. Head camera unit 53 performs imaging of target objects during board work. In the present embodiment, head camera unit 53 is configured to image suction nozzle 44 and the held component from the side. Head camera unit 53 images the component held by suction nozzle 44 as a target object during the mounting process.

Control device 60 is mainly configured by a CPU, various types of memory, and a control circuit. Control device 60 executes a mounting process of mounting components to board 90. In the present embodiment, as shown in Fig. 2, control device 60 includes head control section 61 and notification section 62. In the mounting process, the head control section 61 controls the operation of mounting head 40 based on information outputted from various sensors, measured values, results from image processing by a predetermined calculation unit, a control program that specifies the mounting position on board 90, and the like. Thus, the position and angle of suction nozzle 44 supported by mounting head 40 are controlled.

In addition, notification section 62 sends out predetermined information to the outside during the mounting process. The "outside" described above may include a host computer, a terminal device carried by an operator, and the like. Also, "predetermined information" may include, for example, information about the replenishment of components to component supply device 20, abnormalities, and the need for maintenance of various devices. Notification section 62 sends out predetermined information by, for example, a text message, voice, an indicator light, or the like.

### 3. Detailed configuration of mounting head 40

Mounting head 40 includes head main body 41, driving device 42, rotary head 43, suction nozzle 44, housing 45, control board 46, temperature sensor 47, and cooling fan 48, as shown in Fig. 2. Head body 41 is a frame member which is detachably provided on moving table 32. Driving device 42 is a motor or an actuator for operating various driven portions provided in mounting head 40.

Rotary head 43 is provided in a rotatable manner about the R-axis which is parallel to the vertical axis (i.e., the Z-axis) of head main body 41. Rotary head 43 holds multiple (e.g., 20) syringes in the Z-direction, in a slidable and rotatable manner, at equal intervals along the circumferential direction on a circumference concentric with the R-axis. Suction nozzles 44 are attached to the lower ends of the syringes. Thus, rotary head 43 supports multiple suction nozzles 44 in a rotatable manner around the θ-axis, parallel with the R-axis, passing through the center of each suction nozzle 44, in a manner in which suction nozzles 44 can be lifted and lowered with respect to head main body 41.

Each suction nozzle 44 is a holding member which is supplied with negative pressure air to pick up components. Multiple suction nozzles 44 are angled at predetermined angles around the R-axis by the action of rotary head 43 rotating with the driving of driving device 42. Further, each suction nozzle 44 is rotated about the θ-axis by the operation of driving device 42, thus controlling the rotation angle and rotation speed of suction nozzle 44. Furthermore, suction nozzle 44 is lifted and lowered in the Z-direction by the operation of driving device 42, thus controlling the position and moving speed in the Z-direction.

Housing 45 has a box shape so as to accommodate head main body 41, control board 46, and the like. The lower portion of housing 45 is open so that components held by multiple suction nozzles 44 supported by rotary head 43 can be imaged from below by part camera 51. Further, air inlet 451 is formed on the front face of housing 45. Further, exhaust port 452 is formed on the upper face of housing 45.

Control board 46 is constituted by multiple components arranged on a printed circuit board. Control board 46 is fixed to head main body 41 so that the face on which components are arranged faces intake port 451 of housing 45. Control board 46 is communicatively connected to control device 60 of component mounting machine 1. Control board 46 functions as a head control device for controlling the operation of driving device 42 and the imaging of head camera unit 53 based on instructions received from control device 60 and detected values from various sensors inside mounting head 40.

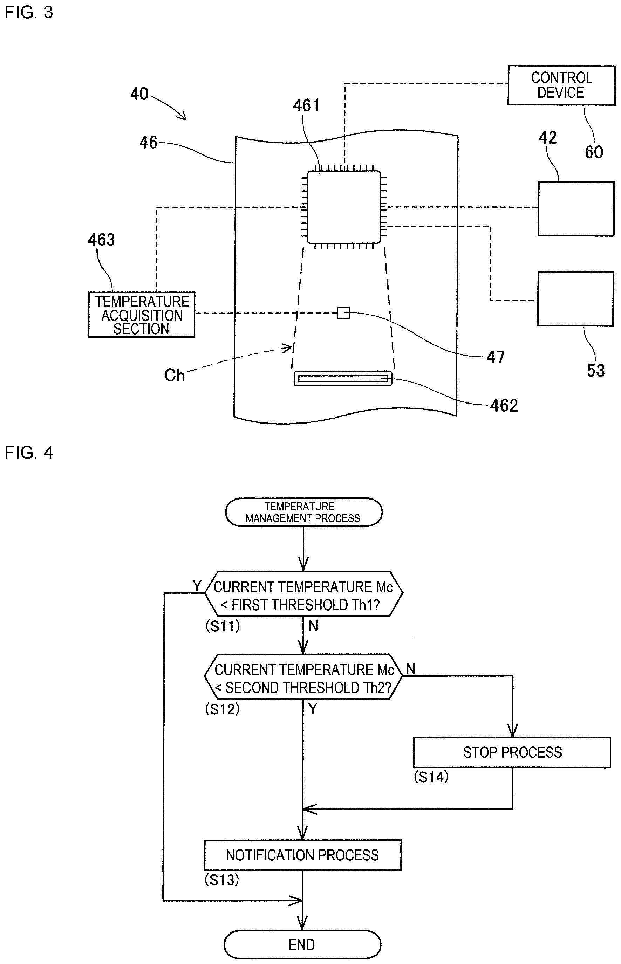

In the present embodiment, control board 46 is connected via an optical cable capable of optical communication with control device 60 of component mounting machine 1. Thus, control board 46 is configured to transmit high-capacity data with control device 60 at a high speed. The components disposed on control board 46 include, as shown in Fig. 3, arithmetic unit 461 and conversion unit 462. Arithmetic unit 461 performs various arithmetic processes. In the present embodiment, arithmetic unit 461 is an FPGA (Field Programmable Gate Array).

Arithmetic unit 461 performs predetermined image processing on the image data acquired by imaging from head camera unit 53. Specifically, arithmetic unit 461, at the time of execution of the mounting process, acquires multiple pieces of image data from head camera unit 53 which captures components picked up by each of the multiple suction nozzles 44. Arithmetic unit 461 then performs a predetermined image process for each piece of image data, and recognizes the presence/absence of the component, the orientation of the component with respect to the suction nozzle 44, and the like.

Conversion unit 462 converts the optical signal used for optical communication between mounting head 40 and control device 60, and the electrical signal used by arithmetic unit 461 in arithmetic processes. In the present embodiment, conversion unit 462 converts the image data transmitted from arithmetic unit 461 to control device 60 into an optical signal. The above image data may include image data acquired by imaging by head camera unit 53 and image data processed by image processing in arithmetic unit 461.

In the present embodiment, control board 46 incorporates temperature acquisition section 463 for acquiring the temperature inside mounting head 40 with hardware such as a CPU and installed software. In the present embodiment, temperature acquisition section 463 acquires the temperature inside mounting head 40 based on the measured value of temperature sensor 47 to be described below.

Temperature sensor 47 measures the temperature at a predetermined position inside mounting head 40. In this embodiment, temperature sensor 47 is disposed on control board 46. Temperature sensor 47 is used, for example, by a thermistor and outputs a measurement value corresponding to the temperature. Thus, temperature acquisition section 463 calculates the temperature at the position where temperature sensor 47 is disposed from the measured value from temperature sensor 47. In this embodiment, temperature sensor 47, as shown in Fig. 3, is disposed between arithmetic unit 461 and conversion unit 462 on control board 46.

Cooling fan 48 cools the inside of mounting head 40. Cooling fan 48 is provided in intake port 451 of housing 45. Cooling fan 48 has fan main body 481 driven by a predetermined supplied power and filter 482 interposed between air inlet 451 and fan main body 481. Filter 482 removes dust and the like in the outside air sucked into mounting head 40 by the driving of fan main body 481.

Air sucked into mounting head 40 by cooling fan 48, after being sent to control board 46, is released to the opening at the bottom of mounting head 40 or to the outside from exhaust port 452 at the top face. Thus, cooling fan 48 cools the interior of mounting head 40, in particular the components that generate heat on control board 46, by generating air flow inside mounting head 40.

### 4. Configuration of thermal management of mounting head 40

There is a demand for reducing the size and weight of mounting head 40 constituting component mounting machine 1 in order to improve the expansion and operability of the area within which mounting head 40 can move. For example, reducing the weight of mounting head 40 is expected to increase the moving speed of mounting head 40 when executing the mounting process, thereby improving productivity. Therefore, in the conventional mounting head, installment of a cooling device or the like has been omitted so that operation can be performed with the minimum number of components required.

In addition, mounting head 40 has various additional functions required to handle the production of various board products. For example, improving the accuracy and the like of the mounting operation can be achieved by a function reflecting results of image processing using head camera unit 53 to the mounting process. Such a function requires, for example, high-speed image processing of high-resolution image data. Therefore, with the function of mounting head 40, there is a need for installing arithmetic unit 461 having a high processing capacity.

Here, arithmetic unit 461 generates heat during operation of mounting head 40. Further, arithmetic unit 461 also consumes more power as the processing capacity is generally increased, thereby increasing the amount of heat generated during operation. Therefore, it is desirable to protect the heat source components and other low heat-resistant components from the heat emitted from the heat source components such as arithmetic unit 461 and maintain a state in which mounting head 40 can operate normally. Therefore, component mounting machine 1 of the present embodiment employs the following configuration to enable temperature management inside mounting head 40.

Specifically, mounting head 40, while cooling the inside with cooling fan 48, is configured such that temperature acquisition section 463 acquires the inside temperature using temperature sensor 47 disposed on control board 46. Furthermore, head control section 61 of control device 60 controls the operation of mounting head 40 in the mounting process based on the temperature acquired by temperature acquisition section 463. Specifically, head control section 61 sends out a notification with notification section 62 to the outside regarding an abnormality when the temperature acquired by temperature acquisition section 463 reaches a preset first threshold Th1.

At this time, notification section 62 sends out a notification, for example, regarding the abnormality of cooling fan 48 to an operator, and prompts for maintenance of cooling fan 48. This is due to the fact that cooling fan 48 is essentially the only means of cooling the inside of mounting head 40 of the present embodiment. For example, malfunctioning of fan main body 481 of cooling fan 48, clogging of filter 482, clogging of air inlet 451 and exhaust port 452 which may affect the operation of cooling fan 48, and the like are abnormalities of cooling fan 48 and are improved by maintenance.

Incidentally, when mounting head 40 is operated in a normal manner, first threshold Th1 described above, for example, is set to a value obtained by adding a predetermined allowable value to the temperature which the inside of mounting head 40 reaches while cooling fan 48 is normally operated. Further, head control section 61 executes a stop process for stopping the operation of mounting head 40 during the mounting process when the temperature acquired by temperature acquisition section 463 reaches second threshold Th2 which is higher than first threshold Th1.

In this stop process, the execution of at least the process (for example, the image processing described above) by arithmetic unit 461, which is a heat source component, is stopped, and the execution of various types of processes (for example, the mounting process using results of image processing) which cannot be continued, are stopped. Second threshold Th2 described above is set below the heat resistance temperature of the component of mounting head 40 having the lowest heat resistance. In the present embodiment, the low heat-resistant component having a heat resistance temperature lower than arithmetic unit 461, which is a heat source component, is conversion unit 462 disposed on control board 46.

For the purpose of, for example, improving traceability, a function of sending and storing all or part of the acquired image data to control device 60 of component mounting machine 1 may be added to component mounting machine 1. In a configuration to which such a function is added, conversion unit 462 capable of converting electrical signals and optical signals at high speed is used because it is necessary to transmit image data having a large data size, due to the increased resolution, at high speeds.

Since conversion unit 462 is a low heat-resistant component, from the viewpoint of countering heating issues, it is preferable to dispose conversion unit 462 away from arithmetic unit 461 which is a heat source component. However, in order to transmit image data and the like having large data sizes with arithmetic unit 461, from the viewpoint of shortening the transmission path, it is preferable for conversion unit 462 to be disposed near arithmetic unit 461. Due to such a circumstance, it is necessary to achieve proper temperature management while enabling high-speed transmission between control device 60 and arithmetic unit 461 so a state is maintained in which conversion unit 462 can operate normally.

In the present embodiment, temperature sensor 47, as shown in Fig. 3, is disposed on control board 46 between arithmetic unit 461, which is a heat source component, and conversion unit 462, which is a low heat-resistant component, and measures the temperature of heat transfer path Ch. Heat generated in arithmetic unit 461 mainly transmits through printed circuit board and reaches conversion unit 462. Therefore, the temperature of conversion unit 462 is considered to be less than or equal to the measured value in heat transfer path Ch.

Therefore, it is possible to reliably prevent the occurrence of defects due to the heat of conversion unit 462 as a result of head control section 61 executing temperature management including the notification process and the stop process based on measured values. Further, by temperature sensor 47 measuring the temperature of heat transfer path Ch, for example, the temperature management process by head control section 61 will be properly executed even when the temperature of the printed circuit board is increased due to a cause other than heat generation of arithmetic unit 461, thereby reliably protecting conversion unit 462 from heat.

### 5. Temperature management process of mounting head 40

The temperature management process of mounting head 40 of component mounting machine 1 having the above-described configuration will be described with reference to Fig. 4. Here, it is assumed that temperature acquisition section 463 periodically acquires the temperature inside mounting head 40 based on the measured value from temperature sensor 47 during execution of the mounting process, and the temperature management process is executed each time. Incidentally, cooling fan 48 is in state in which a predetermined power is supplied.

In the temperature management process, when the acquired current temperature Mc is lower than first threshold Th1 (S11: Yes), head control section 61 determines that conversion unit 462 can operate normally due to being equal to or lower than the current temperature Mc and terminates the current temperature management process. When the acquired current temperature Mc is equal to or higher than first threshold Th1 (S11: No) but lower than second threshold Th2 (S12: Yes), head control section 61 causes notification section 62 to execute a notification process of sending out a notification of an abnormality to the outside (S13).

The notification process is executed at least when the current temperature Mc first exceeds first threshold Th1. Notification section 62 may omit the execution of subsequent notification processes or execute the notification process again after a certain period of time has elapsed, for example. The operator notified of the abnormality of cooling fan 48 by the above notification process (S13) temporarily stops the mounting process at an appropriate timing and performs maintenance of cooling fan 48.

When the acquired current temperature Mc is equal to or higher than second threshold Th2 (S12: No), head control section 61 executes a stop process for stopping the operation of mounting head 40 during the mounting process (S14). Thereafter, head control section 61 issues a warning relating to temperature to an outside operator with notification section 62 and executes a notification process so that maintenance of cooling fan 48 is performed (S13). As a result, execution of the process of arithmetic section 461, which is a heat source component, is stopped, thereby suppressing the temperature rise.

### 6. Effects of the configuration of the embodiment

The board work machine (component mounting machine 1) in the embodiment is provided with a moving head (mounting head 40), used for board work (mounting work, etc.), in a manner allowing movement in the horizontal direction; temperature acquisition section 463 configured to acquire the temperature inside the moving head; and head control section 61 configured to control the operation of the moving head during board work based on the temperature acquired by temperature acquisition section 463.

With such a configuration, the operation of mounting head 40 is controlled by head control section 61 in accordance with the internal temperature. Thus, it is possible to control the temperature inside mounting head 40, thus enabling normal operation of mounting head 40 to be reliably maintained.

### 7. Modification of the embodiment

### 7-1. Temperature sensor

In the embodiment, temperature sensor 47 is disposed on control board 46 between arithmetic unit 461, which is a heat source component, and conversion unit 462, which is a low heat-resistant component, and is configured to measure the temperature of heat transfer path Ch. On the other hand, the temperature sensor may be disposed in a location different from of or in addition to the above location.

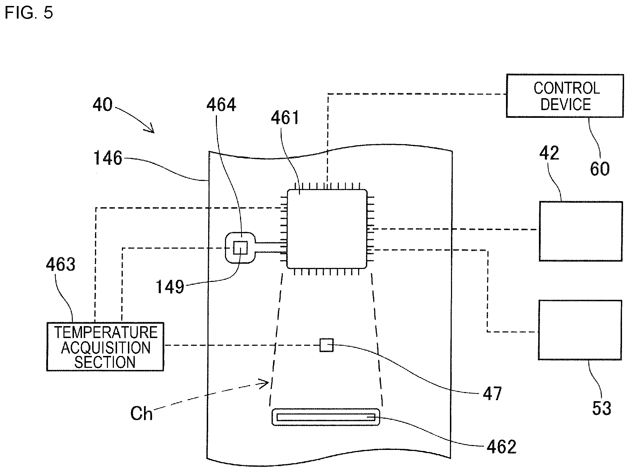

Specifically, mounting head 40 may be configured to have second temperature sensor 149 for measuring the temperature of arithmetic unit 461, as shown in Fig. 5. Second temperature sensor 149 is connected to arithmetic unit 461 by a member having a higher thermal conductivity than the base material of control board 46 and measures the temperature of arithmetic unit 461. For example, land 464, which is a plate-shaped metal, extending to a position where second temperature sensor 149 is disposed and in contact with the bottom face of arithmetic unit 461, can be applied as the "member having a higher thermal conductivity".

With the configuration described above, temperature acquisition section 463 can acquire the temperature of a heat source component such as arithmetic unit 461. Then, based on the temperature of the heat source component, head control section 61 can manage whether the inside of the mounting head 40 is equal to or less than a certain temperature, whether cooling fan 48 is normally operated, or whether a state in which the low heat-resistant component can be normally operated is maintained.

Mounting head 40 may be configured to include two or more temperature sensors. In this case, the two or more temperature sensors may individually measure the temperature of heat transfer path Ch, the temperature of the heat source component, and the temperature of the low heat-resistant component, or the ambient temperature inside mounting head 40. Further, temperature acquisition section 463 executes the temperature management process exemplified in the embodiment based on the measured values of the multiple temperature sensors. In this case, the average of the multiple measured values may be used, or a determination may be added to determine whether each temperature sensor is normal using the difference between the measured values.

In the embodiment, temperature acquisition section 463 is configured to acquire the temperature inside mounting head 40 based on the measured value from temperature sensor 47. In contrast, temperature acquisition section 463 may use a configuration independent of the measured value from temperature sensor 47 as long as it is possible to obtain the temperature of a predetermined position inside mounting head 40. For example, temperature acquisition section 463 may estimate the temperature based on an event that fluctuates in accordance with the temperature change inside mounting head 40.

### 7-2. Temperature management process

In the temperature management process of mounting head 40, head control section 61 executes a notification process (S13) and a stop process (S14) with first threshold Th1 and second threshold Th2 as a two-stage reference. On the other hand, head control section 61 may execute various types of processes based on the temperature acquired by temperature acquisition section 463 with a process different from or in addition to the process described above.

Specifically, when the internal temperature rise of mounting head 40 is assumed to be a cause different from an abnormality of cooling fan 48, head control section 61 may execute a process of identifying the cause of the temperature rise. Further, in order for head control section 61 to suppress the temperature rise of the heat source component so as to, for example, reduce the processing load, a part of the process may be extended or an interval of the process may be omitted.

### 7-3. Configuration of the Board Work Machine

In the configuration of the embodiment, the heat source component is exemplified by arithmetic unit 461, and the low heat-resistant component is exemplified by conversion unit 462. In contrast, components serving as heat source components and low heat-resistant components may be other than arithmetic unit 461 and conversion unit 462. Further, multiple heat source components and multiple low heat-resistant components may be disposed on control board 46.

In the above-described configuration, temperature acquisition section 463 acquires the internal temperature of mounting head 40 based on the measurement value of one or more temperature sensors 47 which are appropriately disposed, for example, on control board 46. Then, by appropriately executing the temperature management process as exemplified in the embodiment based on the temperature acquired by head control section 61, mounting head 40 can be similarly maintained in a state in which normal operation can be performed, or when the temperature rises to a certain level or more, the operation of mounting head 40 can be stopped and protected from heat.

Further, in the embodiment, temperature acquisition section 463 is incorporated into mounting head 40, and head control section 61 is incorporated into control device 60 of component mounting machine 1. In contrast, temperature acquisition section 463 and head control section 61 may each be incorporated into mounting head 40, or may be incorporated into control device 60. In such a configuration, the same effect as in the embodiment can be obtained.

In the embodiment, the board work machine is component mounting machine 1, and the moving head is mounting head 40. On the other hand, in addition to mounting head 40, the moving head may be a head having various functions, such as an application head for applying solder or adhesive to a board. Further, aside from component mounting machine 1, the board work machine may be a printing machine, an inspection machine, or the like as long as it has a moving head. The moving head may be a head for moving a squeegee in the case of a printing machine, or a head for moving an inspection camera in the case of an inspection machine.

### Reference Signs List

1: Component mounting machine (board work machine), 40: Mounting head (moving head), 45: Housing, 46,146: Control board, 461: Arithmetic unit (heat source component), 462: Conversion unit (low heat-resistant component), 463: Temperature acquisition section, 47: Temperature sensor, 48: Cooling fan, 149: Second temperature sensor, 53: Head camera unit (camera device), 60: Control device, 61: Head control section, 62: Notification section, 90: Board, Ch: Heat transfer path, Me: Current temperature, Th1: First threshold, Th2: Second threshold

## Claims

1. A board work machine (1), comprising:
a moving head (40), used for board work, provided inside the board work machine (1) in a manner allowing movement in the horizontal direction;
a temperature acquisition section (463) configured to acquire the temperature inside the moving head (40); and
a head control section (61) configured to control the operation of the moving head (40) during board work based on the temperature acquired by the temperature acquisition section (463), wherein
the board work machine (1) further comprises a notification section configured to send out a notification of an abnormality outside of the board work machine (1) when the temperature acquired by the temperature acquisition section (463) reaches a first threshold value set in advance, wherein the head control section (61) executes a stop process, during board work, for stopping the operation of the moving head (40) when the temperature acquired by the temperature acquisition section (463) reaches a second threshold higher than the first threshold, wherein
the second threshold is set below the heat resistance temperature of the component inside the mounting head having the lowest heat resistance .

2. The board work machine (1) of claim 1, wherein
the moving head (40) comprises:
a control board constituted by multiple components including a heat source component that generates heat during operation of the moving head (40) and a low heat-resistant component whose heat resistance temperature is lower than that of the heat source component, and
a temperature sensor (47) disposed on the control board; and
the temperature acquisition section (463) acquires the temperature inside the moving head (40) based on the measured value from the temperature sensor (47).

3. The board work machine (1) of claim 2, wherein
the moving head (40) is connected to control device of the board work machine (1) in a manner which allows optical communication,
the heat source component is an arithmetic unit configured to perform various arithmetic processes, and
the low heat-resistant component is a conversion unit configured to convert the optical signal used for optical communication and the electrical signal used by the arithmetic unit in arithmetic processes.

4. The board work machine (1) of claim 3, further comprising a camera device, provided inside the moving head (40), configured to image a target object during board work;
wherein
the arithmetic unit performs a predetermined image processing on the image data acquired by imaging with the camera device; and
the conversion unit converts the image data transmitted from the arithmetic unit to the control device into an optical signal.

5. The work machine (1) of any one of claims 2 to 4, wherein
the temperature sensor (47) is disposed on the control board between the heat source component and the low heat-resistant component, and measures the temperature of a heat transfer path.

6. The board work machine (1) of any one of claims 2 to 4, wherein
the temperature sensor (47) is connected to the heat source component by a member having a higher thermal conductivity than the base material of the control board and measures the temperature of the heat source component.

7. The board work machine of claim 1, wherein
the moving head comprises a cooling fan configured to cool the inside of the moving head, and
the notification section sends out a notification regarding an abnormality of the cooling fan.

8. The board work machine (1) of any one of claims 1 to 7, wherein
the board work machine (1) is a component mounting machine configured to perform a mounting process for mounting components on a board, and
the moving head (40) is a mounting head configured to pick up the component during the mounting process and mounts the picked up component to a predetermined position on the board.

## Patentansprüche

1. Platten-Bearbeitungsmaschine (1), die umfasst:
einen beweglichen Kopf (40), der für Plattenbearbeitung eingesetzt wird und im Inneren der Platten-Bearbeitungsmaschine (1) so bereitgestellt ist, dass Bewegung in der horizontalen Richtung ermöglicht wird;
einen Temperaturerfassungs-Teilabschnitt (463), der zum Erfassen der Temperatur im Inneren des beweglichen Kopfes (40) ausgeführt ist; und
einen Kopfsteuerungs-Teilabschnitt (61), der so ausgeführt ist, dass er den Betrieb des beweglichen Kopfes (40) bei Plattenbearbeitung auf Basis der von dem Temperaturerfassungs-Teilabschnitt (463) erfassten Temperatur steuert, wobei
die Platten-Bearbeitungsmaschine (1) des Weiteren einen Benachrichtigungs-Teilabschnitt umfasst, der so ausgeführt ist, dass er eine Benachrichtigung über eine Störung außerhalb der Platten-Bearbeitungsmaschine (1) aussendet, wenn die von dem Temperaturerfassungs-Teilabschnitt (463) erfasste Temperatur einen im Voraus eingestellten ersten Schwellenwert erreicht, wobei der Kopfsteuerungs-Teilabschnitt (61) bei Plattenbearbeitung einen Unterbrechungsvorgang ausführt, um den Betrieb des beweglichen Kopfes (40) zu unterbrechen, wenn die von dem Temperaturerfassungs-Teilabschnitt (463) erfasste Temperatur einen zweiten Schwellenwert erreicht, der höher ist als der erste Schwellenwert, wobei
der zweite Schwellenwert unterhalb der Wärmebeständigkeits-Temperatur des Bauteils im Inneren des Montagekopfes mit der geringsten Wärmebeständigkeit festgelegt wird.

2. Platten-Bearbeitungsmaschine (1) nach Anspruch 1, wobei
der bewegliche Kopf (40) umfasst:
eine Steuerplatine, die aus mehreren Komponenten einschließlich einer Wärmequellen-Komponente, die bei Betrieb des beweglichen Kopfes (40) Wärme erzeugt, und einer Komponente mit niedriger Wärmebeständigkeit besteht, deren Wärmebeständigkeits-Temperatur niedriger ist als die der Wärmequellen-Komponente, sowie
einen Temperatursensor, der an der Steuer-Platine (47) angeordnet ist; und
der Temperaturerfassungs-Teilabschnitt (463) die Temperatur im Inneren des beweglichen Kopfes (40) auf Basis des Messwertes von dem Temperatursensor (47) erfasst.

3. Platten-Bearbeitungsmaschine (1) nach Anspruch 2, wobei
der bewegliche Kopf (40) mit einer Steuerungsvorrichtung der Platten-Bearbeitungsmaschine (1) so verbunden ist, dass optische Kommunikation ermöglicht wird,
die Wärmequellen-Komponente eine Arithmetik-Einheit ist, die zum Durchführen verschiedener arithmetischer Prozesse ausgeführt ist, und
die Komponente mit niedriger Wärmebeständigkeit eine Umwandlungs-Einheit ist, die so ausgeführt ist, dass sie das optische Signal, das für optische Kommunikation genutzt wird, und das elektrische Signal umwandelt, das von der Arithmetik-Einheit in arithmetischen Prozessen genutzt wird.

4. Platten-Bearbeitungsmaschine (1) nach Anspruch 3, die des Weiteren eine Kameravorrichtung umfasst, die im Inneren des beweglichen Kopfes (40) vorhanden und so ausgeführt ist, dass sie ein Bild eines Zielobjektes bei Plattenbearbeitung erzeugt;
wobei
die Arithmetik-Einheit eine vorgegebene Bildverarbeitung an den mittels Bilderzeugung mit der Kameravorrichtung erfassten Bilddaten durchführt; und
die Umwandlungs-Einheit die von der Arithmetik-Einheit zu der Steuerungsvorrichtung übertragenen Bilddaten in ein optisches Signal umwandelt.

5. Bearbeitungsmaschine (1) nach einem der Ansprüche 2 bis 4, wobei
der Temperatursensor (47) an der Steuerplatine zwischen der Wärmequellen-Komponente und der Komponente niedriger Wärmebeständigkeit angeordnet ist und die Temperatur eines Wärmeübertragungs-Weges misst.

6. Platten-Bearbeitungsmaschine (1) nach einem der Ansprüche 2 bis 4, wobei
der Temperatursensor (47) mit der Wärmequellen-Komponente über ein Element mit einer höheren Wärmeleitfähigkeit als der des Trägermaterials der Steuerplatine verbunden ist und die Temperatur der Wärmequellen-Komponente misst.

7. Platten-Bearbeitungsmaschine nach Anspruch 1, wobei
der bewegliche Kopf ein Kühlgebläse umfasst, das zum Kühlen des Inneren des beweglichen Kopfes ausgeführt ist, und
der Benachrichtigungs-Teilabschnitt eine Benachrichtigung bezüglich einer Störung des Kühlgebläses aussendet.

8. Platten-Bearbeitungsmaschine (1) nach einem der Ansprüche 1 bis 7, wobei
die Platten-Bearbeitungsmaschine (1) eine Maschine zum Montieren von Bauteilen ist, die so ausgeführt ist, dass sie einen Montageprozess zum Montieren von Bauteilen auf einer Platte durchführt, und
der bewegliche Kopf (40) ein Montage-Kopf ist, der so ausgeführt ist, dass er das Bauteil während des Montageprozesses aufnimmt und das aufgenommene Bauteil an einer vorgegebenen Position auf der Platte montiert.

## Revendications

1. Machine de travail sur carte (1), comprenant :
une tête mobile (40), utilisée pour un travail sur carte, prévue à l'intérieur de la machine de travail sur carte (1) de manière à permettre un mouvement dans la direction horizontale ;
une section d'acquisition de température (463) configurée pour acquérir la température à l'intérieur de la tête mobile (40) ; et
une section de commande de tête (61) configurée pour commander le fonctionnement de la tête mobile (40) pendant le travail sur carte sur la base de la température acquise par la section d'acquisition de température (463), dans laquelle
la machine de travail sur carte (1) comprend en outre une section de notification configurée pour envoyer une notification d'une anomalie à l'extérieur de la machine de travail sur carte (1) lorsque la température acquise par la section d'acquisition de température (463) atteint une première valeur seuil définie à l'avance, dans laquelle la section de commande de tête (61) exécute un processus d'arrêt, pendant le travail sur carte, pour arrêter le fonctionnement de la tête mobile (40) lorsque la température acquise par la section d'acquisition de température (463) atteint un deuxième seuil supérieur au premier seuil, dans laquelle
le deuxième seuil est fixé en dessous de la température de résistance thermique du composant à l'intérieur de la tête de montage ayant la résistance thermique la plus faible.

2. Machine de travail sur carte (1) selon la revendication 1, dans laquelle
la tête mobile (40) comprend :
une carte de commande constituée de multiples composants comprenant un composant source de chaleur qui génère de la chaleur pendant le fonctionnement de la tête mobile (40) et un composant faiblement résistant à la chaleur dont la température de résistance à la chaleur est inférieure à celle du composant source de chaleur, et
un capteur de température (47) disposé sur la carte de commande ; et
la section d'acquisition de température (463) acquiert la température à l'intérieur de la tête mobile (40) sur la base de la valeur mesurée par le capteur de température (47).

3. Machine de travail sur carte (1) selon la revendication 2, dans laquelle
la tête mobile (40) est reliée au dispositif de commande de la machine de travail sur carte (1) d'une manière qui permet une communication optique,
le composant source de chaleur est une unité arithmétique configurée pour effectuer divers processus arithmétiques, et
le composant faiblement résistant à la chaleur est une unité de conversion configurée pour convertir le signal optique utilisé pour la communication optique et le signal électrique utilisé par l'unité arithmétique dans des processus arithmétiques.

4. Machine de travail sur carte (1) selon la revendication 3, comprenant en outre un dispositif de caméra, prévu à l'intérieur de la tête mobile (40), configuré pour imager un objet cible pendant le travail sur carte ;
dans laquelle
l'unité arithmétique effectue un traitement d'image prédéterminé sur les données d'image acquises par imagerie avec le dispositif de caméra ; et
l'unité de conversion convertit les données d'image transmises de l'unité arithmétique au dispositif de commande en un signal optique.

5. Machine de travail (1) selon l'une quelconque des revendications 2 à 4, dans laquelle
le capteur de température (47) est disposé sur la carte de commande entre le composant source de chaleur et le composant faiblement résistant à la chaleur, et mesure la température d'un chemin de transfert de chaleur.

6. Machine de travail sur carte (1) selon l'une quelconque des revendications 2 à 4, dans laquelle
le capteur de température (47) est relié au composant source de chaleur par un élément ayant une conductivité thermique supérieure à celle du matériau de base de la carte de commande et mesure la température du composant source de chaleur.

7. Machine de travail sur carte selon la revendication 1, dans laquelle
la tête mobile comprend un ventilateur de refroidissement configuré pour refroidir l'intérieur de la tête mobile, et
la section de notification envoie une notification concernant une anomalie du ventilateur de refroidissement.

8. Machine de travail sur carte (1) selon l'une quelconque des revendications 1 à 7, dans laquelle
la machine de travail sur carte (1) est une machine de montage de composants configurée pour effectuer un processus de montage pour monter des composants sur une carte, et
la tête mobile (40) est une tête de montage configurée pour saisir le composant pendant le processus de montage et monte le composant saisi à une position prédéterminée sur la carte.
